# EUROPEAN PATENT APPLICATION

(11) **EP 1 168 429 A1**
(43) Date of publication of application: **02.01.2002**
(21) Application number: 00113121.8
(22) Date of filing: 28.06.2000
(51) Int. Cl.: H01L 21/60, H01L 23/31

(54) **Integrated circuit chip and method for mounting an integrated circuit chip to a circuit board**

(71) Applicant: Telefonaktiebolaget L M Ericsson (Publ), 126 25 Stockholm (SE)
(72) Inventor: Jönsson, Kenth, 692 92 Kumla (SE)
(74) Representative: HOFFMANN - EITLE

(57) **Abstract**

The invention relates to an integrated circuit chip (2), an electronic circuit module (MO1) and a method for mounting such a chip (2) to the surface of a circuit module (1). A frame (4-1) covers at least the side surfaces of the chip (2) and is soldered to the surface of the circuit board (1) via a frame solder pattern (1-3'). This avoids the use of a conventional underfill process and allows a stable mounting of the chip (2) to the circuit board (1).

## Description

### FIELD OF THE INVENTION

The present invention relates to an integrated circuit chip and to a method for mounting same to the surface of a circuit board. The integrated circuit chip has an electrical connection means provided on a major surface thereof, and this electrical connection means is to be contacted to another electrical connection means on the surface of the circuit board.

In particular, the present invention relates to the problem how an integrated circuit chip can be mounted to the surface of the circuit board without using a complicated underfill process which is conventionally used in the prior art. Although the invention can be applied to any type of integrated circuit chip and any type of circuit board, the invention finds particular application when the integrated circuit chip is a CSP (CSP: Chip Scale Package) or a BGA (BGA: Ball Grid Array) or a C4 component, and the circuit board is a printed circuit board (PCB) having an electrical conductor pattern covered with a solder material. However, the invention can be used for any type of circuit board and integrated circuit chip in order to increase the mounting stability between them. In addition, the invention is also applicable to cases where there is a need to mount, instead of the integrated circuit chip, a mechanical component having a connection means to any type of board, for example a circuit board.

### BACKGROUND OF THE INVENTION

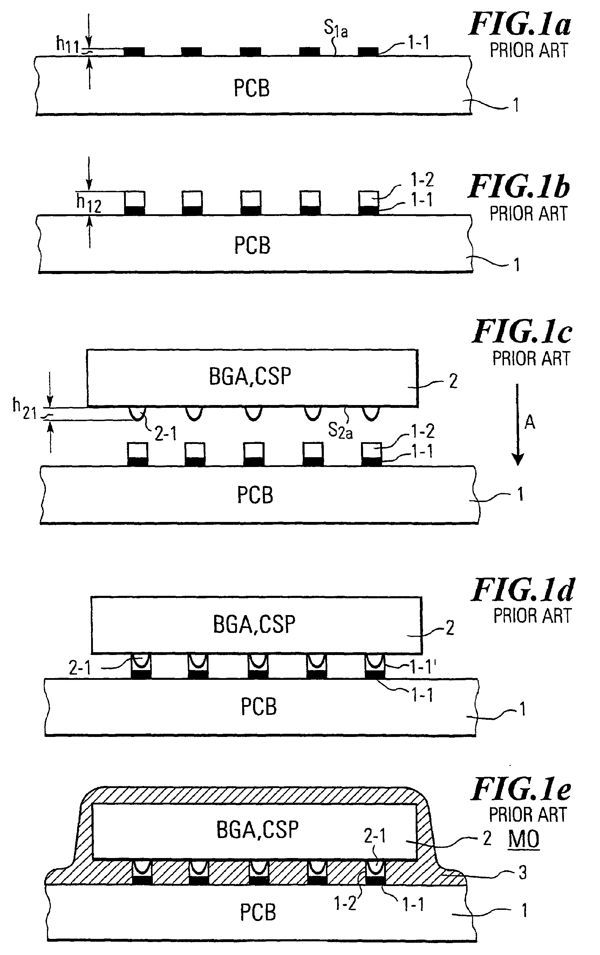

A conventional integrated circuit chip such as a BGA, CSP is shown in Fig. 1c. Typically, the integrated circuit chip has an electrical connection means 2-1 projecting from a major surface S₂ₐ of the integrated circuit chip 2. Typically, this electrical connection means 2-1 is in the form of balls 2-1 which project from the major surface S₂ₐ of the chip 2. The projection height h₂₁ of the balls 2-1 is typically in the order of some hundreds of a millimetre. The balls 2-1 act as contacts which provide an electrical connection to the internal circuitry provided in the integrated circuit chip.

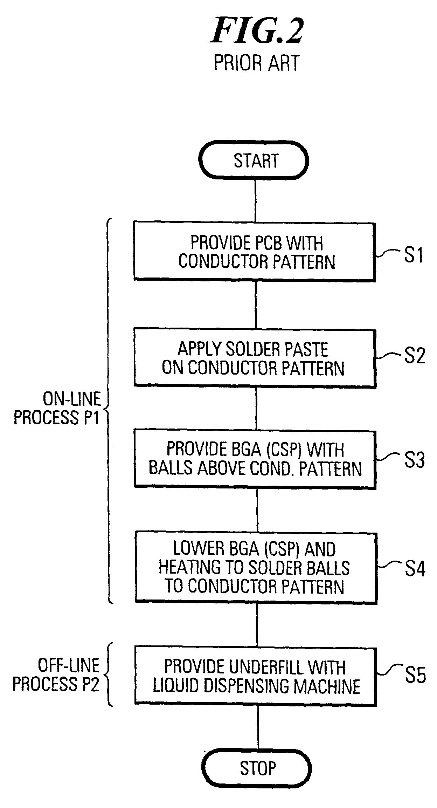

A conventional method for mounting such an integrated circuit chip 2 to a circuit board 1, for example a printed circuit board, is shown in Fig. 2 and will be described with reference to Fig. 1a-1e. In a first step S1 a major surface S₁ₐ of the circuit board 1 is provided with a conductor pattern 1-1 with a conventional process, e.g. via exposing and etching steps. The conductor pattern can be consisting of copper. Depending on the type of circuit board 1 the conductor pattern 1-1 can either project a certain height h₂₁ from the major surface S₁ₐ or it may even be arranged flush to the major surface S₂ₐ.

In step S2 a solder material 1-2 is applied to the conductor pattern 1-1. Typically, such a conductor pattern 1-2 is provided by screen-printing of a solder paste. The result is a complete height h₁₂ projecting from the major surface S₁ₐ of the circuit board 1.

In step S3 the integrated circuit chip 2 described before is arranged above the conductor pattern 1-1 and in correspondence thereto (see Fig. 1c). Of course, the ball pattern of the balls 2-1 must correspond to the solder paste pattern provided on the electrical connection means 1-1 (e.g. stripe conductors on the surface).

As indicated with the arrow A in Fig. 1c, in step S4 the integrated circuit chip 2 is lowered onto the circuit board 1 until the balls 2-1 conduct the solder pattern 1-2. After the balls 2-1 contact the solder material 1-2, heat is supplied such that the balls 2-1 and the conductor pattern 1-1 of the chip 2 and the circuit board 1 are soldered to each other via the solder joints 1-1'. Steps S1-S4 can be carried out in an on-line process P1, i.e. can be carried out automatically in a production line.

Considering that the balls 2-1 are very small and that their projection height h₂₁ is only a view hundreds of a millimetre, further measures need to be taken to ensure a stable mounting of the chip package to the circuit board 1.

The conventional solution is to use a further step S5 for providing an underfill 3 around the chip 2, i.e. underneath, on the side surfaces and on the top surface of the integrated circuit chip 2 and in contact with the major surface S₁ₐ of the circuit board 1. Thus, the complete electronic circuit module MOS shown in Fig. 1e is completed.

However, the underfill process in step S5, as illustrated with Fig. 1e, can only be performed during an offline-process P2 to make sure that the integrated circuit chip (CSP, BGA) will be held stably on the circuit board and will not be forced to loosen from the circuit board. During the underfill process a liquid dispensing machine must be used for dispensing a liquid which can be hardened underneath and preferably also around the integrated circuit chip 2 in an oven. However, the underfill does not always have to enclose the chip. It can just be sucked underneath it. A typical underfill material 3 is a black resin fully covering the integrated circuit chip. Apart from the major disadvantage that the underfill process needs to be carried out in an off-line process P2 which requires additional special equipment and specially trained staff, the dispensed liquid also comprises chemical substances which are dangerous for people's health.

Thus, the underfill process is time-consuming, needs several process steps which can only be carried out off-line, and increases the production costs due to the use of additional equipment and man power.

### PUBLISHED PRIOR ART

Whilst the underfill process is the most widespread used mounting process also other methods are available.

DE 43 23 799 A1 describes a semiconductor arrangement and a method for its manufacturing. A major surface of a semiconductor chip 1 is provided with a wall element consisting of a rectangular frame. This frame is arranged on electrodes provided on the major surface of the semiconductor chip. The frame is connected with a frame-shaped electrode provided on the major surface of the circuit board. The frame is a solder metal for connecting the electrode of the chip with the frame-like electrode on the circuit board. Whilst this allows a secure contacting of the respective electrodes, it will not allow stable mounting of the chip. Therefore, an additional process such as underfill is necessary.

WO 98/323 14 discloses that a chip is mounted via its balls to a rectangular lifter pad provided on the major surface of a circuit board substrate. The chip package has provided on its major surface and on its side surface metallisation terminations which are arranged in a matched relation with corresponding mounting pads on the substrate. These terminations are soldered to the corresponding mounting pads by means of specially designed "optimised" solder joints. In particular, an inner fillet angle is maintained above a predetermined minimum angle to increase solder joint crack initiation time, and the overall solder joint crack propagation length is increased. During a mounting process, the terminations and the balls of the chip are placed in a matched relationship to the corresponding pads provided on the surface of the circuit board, and a simultaneous soldering of the terminations and of the balls is achieved by using a solder reflow oven.

EP 0 732 736 A2 describes that a semiconductor chip has provided on its major surface an electrode pad which does not melt at a temperature employed for a reflow soldering of solder bumps which are used for connecting an electrode pattern of the semiconductor chip to an interconnection substrate. The semiconductor chip is mounted on the inner surface of a cap by a solder and is hermetically sealed in a package body. Whilst the cap allows a secure mounting to the substrate, the mounting process requires several steps such as soldering the chip to the inner surface of the cap.

### SUMMARY OF THE INVENTION

As explained above, in accordance with the conventional mounting process, either an underfill process must be carried out or other complicated steps for securely holding the integrated circuit chip to the circuit board need to be performed. These methods are time-consuming, increase the production costs of the electronic circuit module and do not provide stable mounting.

Therefore, the object of the present invention is to provide an integrated circuit chip and a method for mounting same to the surface of a circuit board which allow a mounting with a high stability without requiring complicated off-line production processes.

This object is solved in accordance with the invention by an integrated circuit chip having an electrical connection means provided on a major surface thereof for connection with a corresponding electrical connection means provided on a major surface of a circuit board, wherein at least the side surfaces of said integrated circuit chip are provided with a continuous frame solderable to a corresponding solder pattern provided on the circuit board.

Furthermore, this object is solved by an integrated circuit module, comprising an integrated circuit chip as defined above and a circuit board having an electrical connection means corresponding to the electrical connection means of the integrated circuit chip and provided with a solder pattern, and having a frame solder pattern corresponding to the frame of said integrated circuit chip provided on a major surface thereof, wherein the electrical connection means of said integrated circuit chip and said circuit board are soldered to each other by the solder pattern, and said frame of said integrated circuit chip and the major surface of said circuit board are soldered to each other via said frame solder pattern.

Furthermore, the object is solved by a mounting method for mounting an integrated circuit chip to a circuit board, comprising the following steps: providing a circuit board with an electrical connection means; providing a solder pattern on said electrical connection means; providing a frame solder pattern on the circuit board; providing an integrated circuit chip having an continuous frame formed at least on side surfaces thereof, and an electrical connection means projecting from a major surface thereof above the circuit board; lowering said integrated circuit chip onto the circuit board such that the electrical connection means of said integrated circuit chip contacts the solder pattern provided on the electrical connection means of the circuit board whilst a distance is kept between the bottom surface of the frame and the frame solder pattern; soldering the electrical connection means of said integrated circuit chip and said circuit board by heating the solder pattern provided on the electrical connection means of said circuit board; after completing the ball soldering, soldering the frame to the major surface of the circuit board via said frame solder pattern.

The integrated circuit chip, the electronic circuit module and the mounting method in accordance with the invention provide the major advantage that a stable mounting can be achieved because the frame will securely hold the integrated circuit chip to the circuit board. A much easier check for positioning of the integrated circuit components on the circuit board is possible. The mounting with the frame completely seals the space between the major surfaces of the chip and the circuit board and thus, unless through-hole wires are provided under the components, the circuit board module can be washed if a screen print failure has been made.

Further advantageous embodiments and improvements of the invention are disclosed in the dependent claims.

Preferably, said solderable frame also covers the top surface of the integrated circuit chip. This further increases the mounting stability and also provides a protection on the top surface of the integrated circuit chip.

Preferably, the bottom surface of the frame and the major surface of the integrated circuit chip are aligned to each other, and the balls constituting the electrical connection means project from the major surface of the integrated circuit chip. This allows an easy positioning of the respective electrical connection means and the frame to their solder material.

Preferably, the sum of the heights of the balls projecting from the major surface of said integrated circuit chip and the height of the electrical connection means with its applied solder pattern is larger than the height of the frame solder pattern, before the soldering process. Thus, it can be ensured that during the mounting process the balls will be soldered first, whereafter the frame is soldered to the surface of the circuit board. Thus, once the balls have been aligned and soldered to the electrical connection means provided on the circuit board, the soldering of the frame will provide the sealing and the stability without misaligning the already soldered balls.

Preferably, the bottom surface of the frame provided on the side surfaces of the integrated circuit chip may also project from the major surface of the integrated circuit chip, wherein a frame-shaped recess can be provided in the circuit board surface for receiving the projecting frame wall. This improves the stability, since the frame after soldering can also not be moved easily sidewards.

Hereinafter, advantageous embodiments of the invention will be described with reference to the attached drawings. However, it should be understood that the present invention is not limited to the described embodiments and the features disclosed in the claims. That is, further advantageous embodiments and improvements of the invention may be derived by combining features and steps which have been separately described in the description and claimed in the claims.

### BRIEF DESCRIPTION OF THE DRAWINGS

- Fig. 1a-1e: show respective stages of a mounting method in accordance with the prior art using an underfill process;
- Fig. 2: shows a flowchart of a mounting method in accordance with the prior art for producing the electronic circuit module MO shown in Fig. 1e;
- Fig. 3a: shows a first embodiment of the integrated circuit chip in accordance with the invention;
- Fig. 3b: shows a second embodiment of the integrated circuit chip in accordance with the invention;
- Fig. 4a-4f: show respective stages when carrying a mounting method in accordance with an embodiment of the mounting method in accordance with the invention;
- Fig. 4d': shows another embodiment similar as in Fig. 4d where a small distance w is kept between the frame and the solder pattern on the board, especially useful for integrated circuit chips with small balls, such as C4 components;
- Fig. 4g: shows an electronic circuit module MO2 similar to the electronic circuit module MO1 shown in Fig. 4f, using the second embodiment of the integrated circuit chip shown in Fig. 3b; and
- Fig. 5: shows a flowchart of the mounting method in accordance with the embodiment for producing the respective stages as shown in Fig. 4a-f.

### EMBODIMENTS OF THE INTEGRATED CIRCUIT CHIP

Hereinafter, the invention will be described with particular reference to embodiments relating to the mounting of an integrated circuit chip having an electrical connection means to a circuit board. However, the invention can equally be applied to the cases where instead of the integrated circuit chip simply a mechanical component is to be mounted to a board . The board can be any type of board, for example a circuit board.

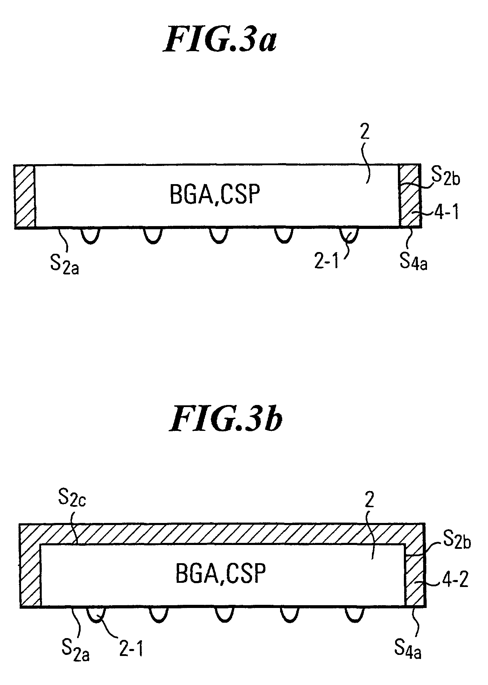

Fig. 3a and Fig. 3b show two embodiments of the integrated circuit chip in accordance with the principle of the invention.

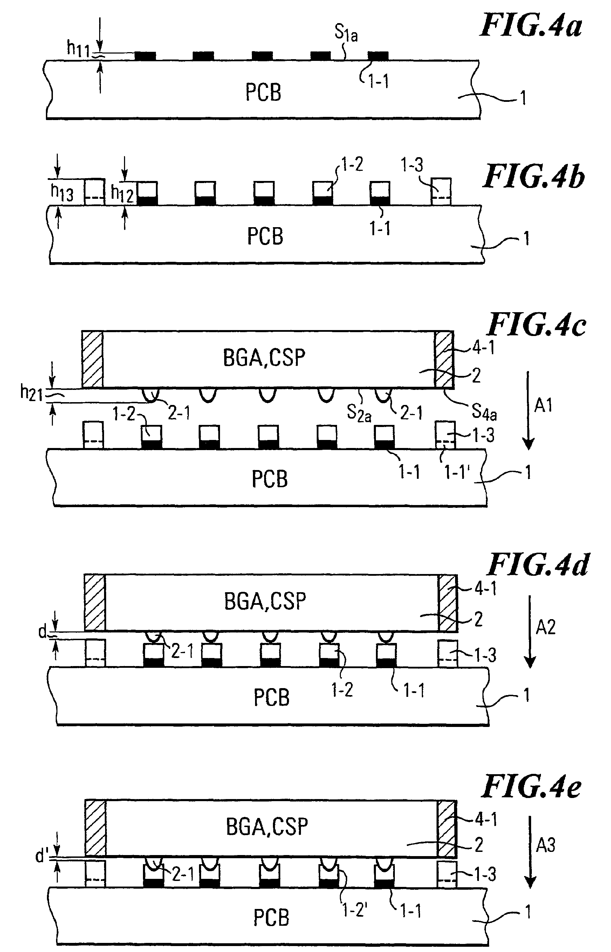

The integrated circuit chip CSP, BGA, 2 has an electrical connection means 2-1 provided on a major surface thereof S₂ₐ. The electrical connection means 2-1 is provided for connection with a corresponding electrical connection means 1-1 provided on a major surface S₁ₐ of a circuit board PCB, 1, as shown in Fig. 4b.

The BGA or CSP or C4 integrated circuit (IC) chip (Fig. 3a and Fig. 3b) has one top and one bottom and four side surfaces. In accordance with the principle of the invention, at least the side surfaces S_{2b} of said integrated circuit chip CSP, BGA, 2 are provided with a continuous frame 4-1; 4-2 which can be soldered. This continuous frame 4-1; 4-2 is to be soldered to a corresponding frame solder pattern 1-3 provided on the circuit board PCB, 1, as shown in Fig. 4b.

For example, the continuous frame 4-1; 4-2 may be a gold plating or any other solderable material on the frame. The electrical connection means 2-1 provided on the major surface S₂ₐ of the integrated circuit chip BGA, CSP, 2 can be plurality of balls 2-1. The balls on the major bottom surface S₂ₐ are only some hundreds of microns high, as is well-known in the art of BGAs, CSPs.

In accordance with the first embodiment of the integrated circuit chip in accordance with the invention, shown in Fig. 3a, the bottom surface S₄ₐ of the continuous frame 4-1 is arranged flush with the major surface S₂ₐ of the chip 2. Furthermore, in the embodiment in Fig. 3a the frame 4-1 is only provided on the side surfaces S_{2b} of the chip 2.

In accordance with a further embodiment of the integrated circuit chip in accordance with the invention, as shown in Fig. 3b, the frame is also provided on the top surface S_{2c} of the chip 2, thus fully surrounding the integrated circuit chip 2 with the exception of the major surface S₂ₐ where the balls 2-1 are provided.

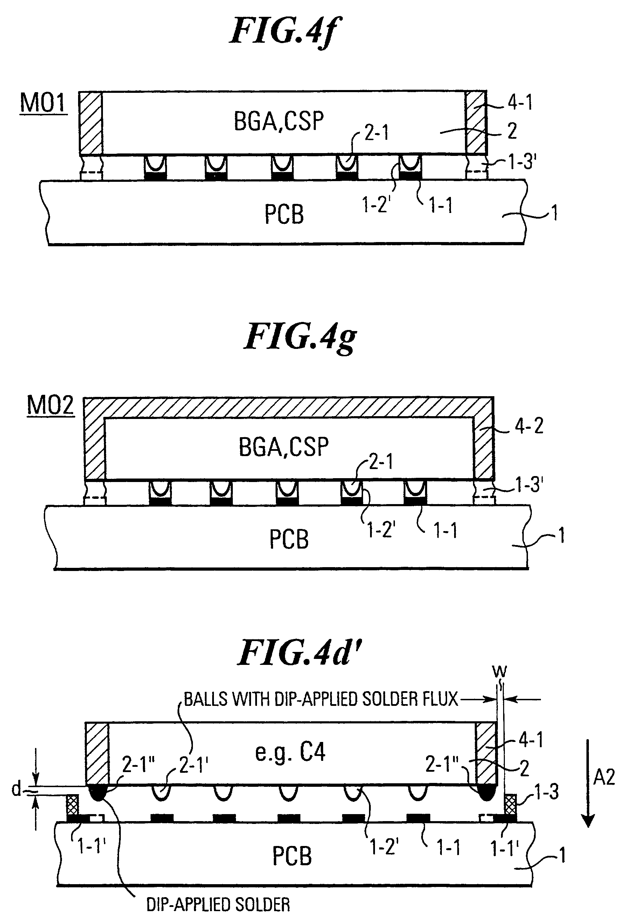

When the integrated circuit chips having frames provided as shown in Figs. 3a, 3b are mounted on the circuit board 1 (the mounting method will be described hereinafter), an electronic circuit module MO1, as shown in Fig. 4f, or an electronic circuit module MO2, as shown in Fig. 4g, results. In particular, the four edges of the frame will be soldered to the surface of the circuit board 1 to keep the component (chip) more stabilized on the circuit board. A much easier check of the positioning of the components is possible on the circuit board.

Although in the embodiments in Fig. 3a and Fig. 3b the bottom surface S₄ₐ of the frame 4-1; 4-2 is shown to be aligned (i.e. flush) with the major surface S₂ₐ, other embodiments of the frame 4-1; 4-2 can also comprise a projecting bottom surface S₄ₐ (i.e. projecting from the major surface S₂ₐ) and a recessed or set back bottom surface S₄ₐ such that a step is formed between the bottom surface S₄ₐ of the frame 4-1; 4-2 and the major surface S₂ₐ of the integrated circuit chip BGA, CSP. The special usage of such a set back bottom surface or projecting surface will be explained hereinafter with respect to the mounting process shown in Figs. 4a-4f.

As can be seen from Fig. 4f, by providing the integrated circuit chip 2 with the frame 4-1; 4-2, at least on the side surfaces there is no need for an underfill process, as described above with reference to Fig. 1e. That is, the frame 4-1 which is soldered to the major surface S₁ₐ of the chip 1 via the frame solder pattern 1-3 fully encloses the space underneath the major surface S₂ₐ and thus fully seals and encloses the integrated circuit chip 2 onto the surface of the circuit board 1. This means that on all four sides of the integrated circuit chip component there will be soldered joints to keep the integrated circuit chip more stabilized on printed circuit board 1. Since the integrated circuit chip 2 is provided with the frame 4-1; 4-2, the complete mounting process can be carried out in an on-line process, i.e. it can be carried out automatically on a production line. That is, no steps of using a liquid dispensing machine and an oven for hardening the underfill material 3, as in Fig. 1e, is necessary any longer.

Whilst above it has been described that at least the side surfaces are covered with the frame, it may be sufficient to only cover two opposing sides S_{2b} of the integrated circuit chip 2 with the frame 4-1. In this case, it will still be easier to have air flowing around the balls during the mounting process, as will be described below with reference to Figs. 4a, 4f.

### EMBODIMENT OF THE MOUNTING METHOD

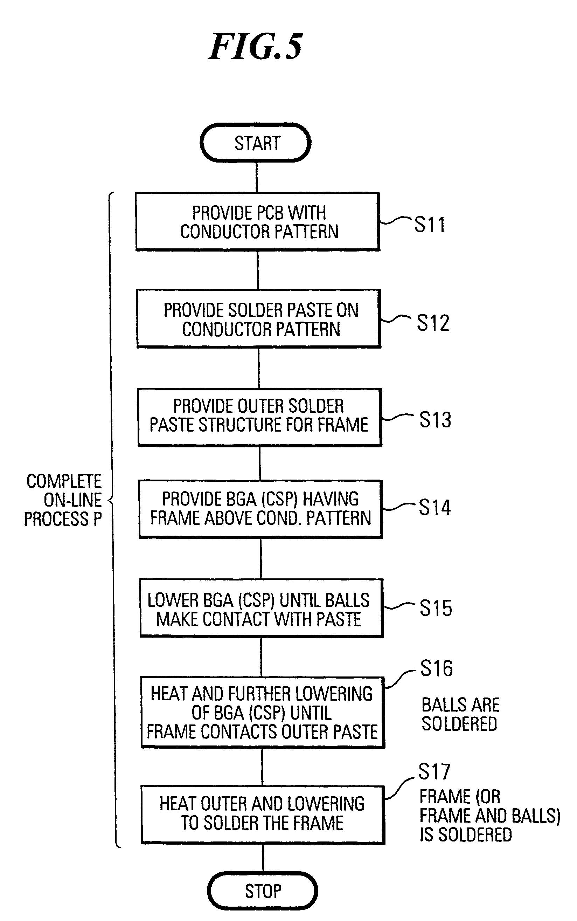

An integrated circuit chip having a frame at least on one or more side surfaces of the integrated circuit chip, as shown in Fig. 3a, Fig. 3 b, and as described above, can be mounted to a circuit board PCB, 1 in accordance with the steps shown in the attached Fig. 5. The steps S11-S17 in Fig. 5 correspond to the respective stages during the manufacture, as shown in Fig. 4a - Fig. 4f. The result of mounting the integrated circuit chip 2 to the printed circuit board PCB, 1 is an electronic circuit module MO1, as shown in Fig. 4f or, if the fully surrounding frame 4-2 in accordance with the embodiment in Fig. 3b is used, to an electronic circuit module MO2, as shown in Fig. 4g.

In step S11 a circuit board PCB, 1 is provided with an electrical connection means 1-1 having a height h₁₁ on the major surface S₁ₐ, as shown in Fig. 4a. This step corresponds to step S1, as shown in Fig. 2 and shown in Fig. 1a. This type of electrical connection means 1-1 may be a conductor pattern on the printed circuit board 1. A preferable material for it is copper, aluminium of silver.

In step S12 in Fig. 5, similarly as in step S2 in Fig. 2, a solder pattern 1-2 is provided on the electrical connection means 1-1. The total height of the conductor pattern 1-1 plus the applied solder pattern 1-2 amounts to a height h₂₁, as shown in Fig. 4b.

However, in addition to the structure in Fig. 1b, in step S13 in Fig. 5 additional frame solder pattern 1-3 is provided on the major surface S₁ₐ of the printed circuit board PCB, 1. Its width amounts to about 0.5 mm, i.e. a width corresponding to the width of the frame 4-1; 4-2. The height of the frame solder pattern 1-3 amounts to h₁₃. Typical heights for h₁₁ and h₁₃ are h₁₁ = 35 µm (±15) and h₁₃ = 0.127 mm (5 MIL). A typical height h₂₁ for the projecting balls 2-1 is e.g. for a BGA h₂₁ = 0.25 mm to 0.4 mm, i.e. 250 to 400 µm. The dimension h₁₂ can be from 0.147 mm to 0.177 mm.

The frame solder pattern 1-3 applied to the major surface S₁ₐ of the printed circuit board 1 in step S13 may only comprise a frame solder pattern consisting of solder paste. Alternatively, the solder pattern 1-3 may also be provided on a part of the conductor pattern 1-1 (as schematically illustrated with the horizontal dotted line in the frame solder pattern 1-3 in Fig. 4b).

Further preferably, although not shown in Fig. 4b, it may also be provided that the entire frame solder pattern 1-3 is arranged in a recess corresponding to the provision of the frame 4-1 on the side surfaces of the integrated circuit chip 2. Such an arrangement is particular advantageous if a projecting bottom surface S₄ₐ of the frame 4-1 is used, as will be explained below with more details.

In step S14 the integrated circuit chip 2 with its provided frame 4-1 is arranged above the circuit board 1 such that the frame 4-1 corresponds to the frame solder pattern 1-3, and the balls 2-1 correspond to the conductor pattern 1-1 with its applied solder paste 1-2. If the bottom surface S₄ₐ of the frame is aligned to the bottom surface S₂ₐ of the integrated circuit chip 2 and no recess for the frame solder pattern 1-3 is used in the printed circuit board 1, it must be guaranteed that the height h₂₁ of the balls 2-1 projecting from the major surface S₂ₐ of said integrated circuit chip BGA, CSP 2 plus the height h₂₁ of the solder pattern 1-2 and the conductor pattern 1-1 of said circuit board is, before soldering, larger than the height h₁₃ of said frame solder pattern 1-3 projecting from the surface S₁ₐ of the circuit board 1. As will be seen below with reference to Fig. 4d, 4e and 4f, this ensures that the frame 4-1 will not be soldered until the balls 2-1 have been soldered and the integrated circuit chip has come closer to the circuit board 1.

In step S15 and as indicated with the arrow A1 in Fig. 4c, the integrated circuit chip 2 is now lowered onto the circuit board such that the electrical connection means 2-1 (the balls) of the integrated circuit chip contact the solder pattern 1-2 provided on the conductor pattern 1-1 of the circuit board 1, and when making contact, due to the aforementioned height relationships, a distance d is still be kept between the bottom surface S₄ₐ of the frame 4-1; 4-2 and the frame solder pattern 1-3.

In step S16 the balls 2-1 are soldered to the conductor pattern 1-1 by heating the solder paste 1-2 provided on the conductor pattern 1-1. The result is shown in Fig. 4e where the solder joints 1-2' provide a secure connection between the balls 2-1 and the conductor pattern 1-1. However, even when the soldering process for the balls 2-1 has been finished, there is still a certain distance d' between the frame solder pattern 1-3 and the frame 4-1 due to the aforementioned height relationship. Therefore, even if the chip 2 further lowers during the soldering and heating process, as indicated with the arrow A2, there will still be a distance d' which is of course smaller than the distance d shown in Fig. 4d.

After finishing step S16, further heating is provided in Fig. 4e such that the chip 2 further lowers, as indicated with the arrow A3. That is, now the four edges of the frame touch the paste 1-3 and will also be soldered to the surface of the circuit board 1 via the solder joints 1-3', as shown in Fig. 4f. Fig. 4f shows the completed electronic circuit module MO1 comprising the integrated circuit chip 2 with its frame fully soldered at the frame and at the balls to the conductor pattern and to the surface of the PCB board 1. This means, that on all four sides of the integrated circuit chip 2, there will be soldered joints 1-3' to keep the integrated circuit chip 2 more stabilized on the circuit board 1.

Since the balls 2-1 are first soldered to the conductor pattern 1-1 while a distance d is kept (see Fig. 4d), air can still flow around the balls during the first soldering process. Only after the balls have been soldered, the frame touches the paste and is also soldered to the board.
Whilst Fig. 4f shows an electronic circuit module MO1 for the embodiment shown in Fig. 3a, Fig. 4g shows a second embodiment of the electronic circuit module MO2 when using the second embodiment of the integrated circuit chip 2, as shown in Fig. 3b.

Thus, as shown in Fig. 4f, Fig. 4g, the electronic circuit module MO1, MO2 comprises an integrated circuit chip package 2 which is surrounded at least on the side surfaces by a frame 4-1; 4-2 which is soldered to the surface of the circuit module 1. If, for example, the frame solder pattern 1-3 is indeed provided also on a conductor 1-1, as was mentioned above, it may be possible to ground the conducting frame 4-2 when it is soldered to such a grounding conductor. Therefore, the additional frame 4-2 cannot only serve as a stabilizing means but also serve as an EMC shielding for the integrated circuit chip 2 at the same time.

Above, it was already explained that the bottom surface S₄ₐ may also project from the major surface S₂ₐ of the integrated circuit chip 2. Of course, in such a case the height of the frame solder pattern 1-3 (possibly including the height of the grounding conductor 1-1 provided underneath the frame solder patent 1-3) must be correspondingly reduced such that the above-mentioned height relationships are still kept, such that a distance d is guaranteed when the balls 2-1 contact the solder paste 1-2.

Alternatively, the frame solder pattern 1-3 may be provided in a recess corresponding in geometry to the provision of the frame 4-1 on the side surfaces of the integrated circuit chip. That is, the frame solder pattern 1-3 may be flush with the major surface S₁ₐ of the circuit board 1 or it may be not, depending on the projection height of the bottom surface S₄ₐ. However, preferably the frame solder pattern 1-3 (with its possibly provided conductor 1-1) may be fully received in the recess such that in a condition in Fig. 4d (when the balls 2-1 contacted the solder paste 1-2) the frame 4-1 projection is already inserted into the recess which provides further stabilization and positioning during the soldering process even for the balls 2-1. However, even in this case the depth of the recess filled with the frame conductor pattern 1-3 plus the projection height of the bottom surface S₄ₐ of the frame 4-1 must be smaller than the sum of the height h₂₁ and h₁₂.

Of course, the above Fig. 4c only shows one preferred embodiment where for example the width of the balls 2-1, the width of the conductor pattern 1-1 and the width of the solder paste 1-2 is substantially the same and the width of the frame 4-1 and the width of the frame solder pattern 1-3 is substantially the same. However, it may be provided that the width of the conductor pattern 1-1 and/or the width of the solder paste 1-2 are wider than the width of the balls 2-1 and that the width of the frame solder pattern 1-3 is wider than the width of the frame 4-1. This can increase the joint strength.

Furthermore, Fig. 4c only shows one possibility where the frame solder pattern 1-3 (width) is substantially aligned to the frame 4-1 (width). However, as shown in the separate Fig. 4d', it may be provided that the balls 2-1 (width) and the conductor pattern 1-1/solder pattern 1-2 (width) are substantially aligned and that the frame 4-1 (width) and the frame solder pattern 1-3 are slightly misaligned in the lateral direction such that a distance w is kept between the inner surface of the solder paste 1-3 and the frame outside surface.

For example, if the frame 4-1 and a solder frame 1-1' (e.g. similar to the conductor pattern 1-1) indicated with the dotted line in the frame solder pattern 1-3 in Fig. 4c have a width of e.g. 0.5 mm, the solder frame 1-1' can be moved slightly outwards to the left and the right side of the circuit board, respectively, such that only 0.15 mm of the width of the solder frame 1-1' is under the frame 4-1 and 0.35 mm of the width is outside the frame 4-1. Then, there is the possibility to arrange a solder paste 1-3 string on the solder frame 1-1' in such a manner and with such a width that a certain distance w is kept between the side of the solder pattern 1-3 in the inward direction and the outside surface of the frame 4-1. For the above mentioned dimensions, it could for example be provided that a 0.25 mm wide solder paste 1-3 is provided on the solder frame 1-1' of 0.5 mm width (0.35 mm width outside the frame 4-1 and 0.15 mm width under the frame 4-1) in such a manner that it would be aligned to the outside edge of the solder frame 1-1' which results in a distance of w = 0.1 mm between the inner side of the solder paste 1-3 and the outward directed surface of the frame 4-1. This can serve as a safeguard measure not to solder the frame 4-1 before soldering the balls 2-1.

Similar considerations to move out the solder frame and keeping a distance of course similarly apply to the case where a recess is provided in the board surface for receiving a solder frame with solder paste or just receiving the solder paste. In this case the recess would also be slightly misaligned from the frame in the outside direction of the board.

The arrangement with keeping a certain distance w is particularly advantageous when using C4 components for the integrated circuit chip. These components are usually smaller than BGAs or CSPs but still have balls. However, the balls have a diameter of only 100 to 200 microns. This means that it is difficult to print a solder paste 1-2 on the circuit board with such small dimensions.

Therefore, the C4 component already has applied to the balls before the mounting a solder material (the frame may or may not be applied with some solder material). Therefore, before mounting, the C4 component must be dipped into some solder flux to be able to solder the balls with the applied solder. With this dipping the small balls 2-1' (and possibly also the frame if it has been provided with solder) can be provided with the solder flux 2-1', 2-1'' as shown in Fig. 4d' (i.e. they may have substantially the same projection height from the bottom surface of the chip) and - in case of a printed solder paste 1-2 on the conductor pattern 1-1 on the circuit board - this would invariably lead to a situation where the solder paste 1-3 on the board and the frame (or the solder with the dip-applied solder flux 2-1'' on the frame) will touch each other before the balls 2-1' with the solder and the dip-applied solder flux touch the solder 1-2.

Although in Fig. 4d' the situation is shown where the frame has also been applied with the solder and the solder flux, of course, the similar situation occurs if only the balls of the C4 component have applied solder and the frame has not been applied with solder before the mounting. Then, the dipping in the solder flux only causes the balls to be applied with the solder flux whilst the solder flux will not adhere to the frame. In this case, only the balls 2-1' with the solder and the applied solder flux are present and the solder/solder_ flux 2-1'' is not present, i.e. is not projecting from the bottom surface. Depending on the height relationship of the height of solder paste 1-3 (or the conductor 1-1' plus the solder paste 1-3) on the circuit board and the height of the conductors 1-1 on the circuit board (plus the height of the projecting solder/solder flux applied balls 2-1') a situation may also arise here where first the frame 4-2 makes contact with the solder paste 1-3' before the balls 2-1' make contact with the conductor 1-1).

If in the afore mentioned two cases the "misaligned arrangement" as described above and shown in Fig. 4d' is used this situation of contact can be avoided because a sideward distance w is kept. This is advantageous because the ball height is very small and there is no solder paste on the circuit board conductor whilst a rather high solder paste 1-3 is used for the frame such that without keeping a lateral spacing w the balls would make contact after the frame makes contact which is to be avoided since first the balls need to soldered and only afterwards the frame should be soldered. The lateral spacing allows first to solder the balls also for the case where the height relationship before soldering is such that the frame would otherwise be soldered first.

Thus, for the C4 or similar component with small balls, it is preferred to have no solder pattern 1-2 on the conductor pattern 1-1, to have no solder on the frame, to provide a misaligned solder pattern 1-3 or a misaligned solder pattern 1-3 on a conductor pattern 1-1 for soldering the frame 4-1, and to dip the component into some solder flux to have the balls applied with solder flux. If the frame is already provided with the solder there may be no necessity to provide an additional solder pattern (e.g. printed) 1-3 on the board. However, it may be additionally provided as shown in Fig. 4d'.

Of course, as indicated with the dotted lines at the solder frame 1-1' in Fig. 4d', the solder frame 1-1' may also be provided in alignment to the frame 4-1 however still with the extended outer side surface to allow the application of the solder paste pattern 1-3 in the "misaligned manner" with keeping the distance w. Furthermore, it is also possible that the solder paste 1-3 is partially still provided on the surface of the solder frame 1-1' directly opposite the dip-applied solder frame 2-1'', as long as it is guaranteed that the height relationships are such that first the balls 2-1' with the dip-applied solder flux touch the conductor pattern 1-1 before the frame (possibly with the dip applied solder flux 2-1'') will touch the surface of the solder frame 1-1' or the surface of the solder paste 1-3 applied thereon and only thereafter the frame or the frame applied with the dip solder flux contacts the solder 1-3 on the solder frame 1-1'.

Although not shown in Fig. 4d', it is also possible to still provide additionally a solder paste 1-2 on the conductor pattern 1-1 even when the very small balls 2-1' are to be soldered. If the balls are very small but have a relatively large distance to each other the conductor pattern 1-1 may be formed wider than the ball width such that the contacting can be performed in a similar manner as in Fig. 4d. The height relationships to first contact the balls and then the frame must also be observed in this case.

Alternatively or additionally, the touching can be avoided if the frame bottom surface is not aligned to the bottom surface of the chip, i.e. the bottom surface of the frame is slightly retracted from the bottom surface of the chip. In this case the frame without solder/solder flux or a frame with a possibly dip-applied solder/solder flux on the frame may not be projecting to the same height from the bottom surface of the chip as the balls with their dip-applied solder.

### EMBODIMENT OF THE ELECTRONIC CIRCUIT MODULE

Fig. 4f and Fig. 4g show two embodiments of electronic circuit modules MO1, MO2 in accordance with the invention. They comprise an integrated circuit chip BGA, CSP, 2, as shown in Fig. 3a and Fig. 3b and as described above, and the circuit board having the electrical connection means 1-1 corresponding to the electrical connection means 2-1 of the integrated circuit chip and provided with a solder pattern 1-2, and having a frame solder pattern 1-3 corresponding to the frame 4-1; 4-2 of the integrated circuit chip provided on a major surface S₁ₐ thereof.

The frame 4-1 is soldered to the surface S₁ₐ of the printed circuit board 1 via a solder joint 1-3' and the balls 2-1 (the electrical connection means of the chip 2) are soldered to the conductor pattern 1-1 via other solder joints 1-2'.

Another embodiment is shown in Fig. 4g where the frame 4-2 fully surrounds the integrated circuit chip 2. Apart from allowing a much easier check of the positioning of the integrated circuit chips 2 on a printed circuit board, the electronic circuit module or the electronic circuit board 2 can also be washed far more easily if one has done a screen print failure. This will reduce the cost for production of such integrated circuit modules because the integrated circuit modules will be able to stand a washing process. That is, the frame 4-1 which is continuous and fully surrounds the integrated circuit chip 2 is soldered via the (continuous) joints 1-3' to the surface S₁ₐ of the circuit board 1 in such a manner that a completely sealed space between the major surfaces of the chip 2 and the circuit board 1 is provided.

### INDUSTRIAL APPLICABILITY

Unlike the underfill process in accordance with the prior art which is an expensive off-line process, and which also has a great impact on the possibility to repair the components which are underfilled and also of adjacent components, the present invention suggests to provide a frame continuously at least on the side surfaces of an integrated circuit chip package. This continuously surrounding frame is soldered to the surface of the circuit board 1 after the balls of the chip package have been soldered to corresponding conductor patterns. It may be noted that not all of the balls 2-1 may have to be contacted with conductor patterns 1-1 such that some of the conductor stripes 1-1 may be omitted. Furthermore, it may be noted that the frame 4-1 may only be provided on one or more of the side surfaces of the chip 2, i.e. if there are adjacent chips 2 which cover the remaining side surfaces.

Furthermore, it may be noted that the side frame 4-1 may also be soldered to a side frame 4-1 of an adjacent integrated circuit chip 2. It may also be possible to provide the side frame 4-1 with special projections and recesses which allow a physical interlocking of respective frames. This further increases the stability of each of the electronic circuit modules.

Whilst the integrated circuit chips 2 or the electronic circuit modules may be used in any electronic device, they are used to a great advantage in electronic devices which may be subject to large forces. For example, preferably the invention may be used in communication devices such as PDAs, telephones, or preferably in mobile telephones. A cheaper production of the electronic circuit modules and thus of such electronic devices may be achieved.

Heretofore, the invention was described with particular reference to embodiments relating to the mounting of an integrated circuit chip having an electrical connection means to a circuit board. However, the invention can equally be applied to the cases where instead of the integrated circuit chip simply a mechanical component is to be mounted to a board . The board can be any type of board, for example a circuit board. In this case, the mechanical component and the board comprise, instead of the electrical connection means, connection means which have the some configuration as the electrical connection means described above and are solderable. However, the connection means may of course be an electrical connection means just as in the case of the integrated circuit chip/circuit board mounting. For example, the electrical connection means may of course be constituted as the above described balls. However, the may also have an electrical connection means constituted by ordinary leads which substantially reach out of the body. In this case, the mounting will be slightly different, because e.g. in Fig. 4d and Fig. 4e leads instead of the balls 2-1 will be soldered to a conductor pattern on the circuit board. However, the mounting is substantially still the same as the process shown in Fig.4, i.e. first the leads will be soldered (whilst the frame does not touch its solder pattern) and then the frame of the mechanical component will be soldered to its corresponding solder pattern on the board once the leads have been substantially fixed. Furthermore, the integrated circuit chip of the invention can be a BGA, a CSP or a C4 component or any other type of integrated circuit chip having an electrical connection means in the sense as described above.

Furthermore, it should be noted that other modifications and variations of the invention can be carried out on the basis of the attached drawings, the description and the claims. In particular, the invention may comprise embodiments of features which have been separately described in the description and in the figures and claimed in the claims.

Reference numerals in the claims only serve clarification purposes and do not limit the scope of protection.

## Claims

1. An integrated circuit chip (CSP, BGA, 2) having an electrical connection means (2-1) provided on a major surface thereof (S₂ₐ) for connection with a corresponding electrical connection means (1-1) provided on a major surface (S₁ₐ) of a circuit board (PCB, 1),
***characterized in that***
at least the side surfaces (S_{2b}) of said integrated circuit chip (CSP, BGA, 2) are provided with a continuous frame (4-1; 4-2) solderable to a corresponding solder pattern (1-3) provided on the circuit board (PCB, 1).

2. An integrated circuit chip according to claim 1,
***characterized in that***
said solderable frame (4-1; 4-2) also covers the top surface (S_{2c}) of said integrated circuit chip.

3. An integrated circuit chip according to claim 1,
***characterized in that***
said electrical connection means (2-1) of said integrated circuit chip comprises a plurality of balls (2-1) provided on said major surface (S₂ₐ) of said integrated circuit chip.

4. An integrated circuit chip according to claim 1,
***characterized in that***
the bottom surface (S₄ₐ) of said frame (4-1) and the major surface (S₂ₐ) of said integrated circuit chip are aligned to each other and said balls (2-1) project from said major surface (S₂ₐ) of said integrated circuit chip.

5. A integrated circuit chip according to claim 1,
***characterized in that***
said frame (4-1) project from said major surface (S₂ₐ) of said integrated circuit chip.

6. An electronic circuit module (MO1, MO2), comprising an integrated circuit chip (BGA, CSP, 2) according to one or more of the preceding claims and a circuit board (PCB, 1) having an electrical connection means (1-1) corresponding to the electrical connection means (2-1) of the integrated circuit chip and provided with a solder pattern (1-2), and having a frame solder pattern (1-3) corresponding to the frame (4-1; 4-2) of said integrated circuit chip provided on a major surface (S₁ₐ) thereof, wherein the electrical connection means (2-1; 1-1) of said integrated circuit chip (2) and said circuit board (1) are soldered to each other by the solder pattern (1-2), and said frame (4-1; 4-2) of said integrated circuit chip and the major surface (S₁ₐ) of said circuit board are soldered to each other via said frame solder pattern (1-3).

7. An electronic circuit module according to claim 5,
***characterized in that***
said solder patterns (1-2; 1-3) for connecting the electrical connection means (2-1; 1-1) and said frame (4-1; 4-2) is a screen-printed solder paste provided on the electrical connection means (1-1) of said circuit board (PCB, 1) and the major surface (S₁ₐ) of said circuit board (PCB, 1).

8. An electronic circuit module according to claim 5,
***characterized in that***
the bottom surface (S₄ₐ) of said frame (4-1; 4-2) is aligned with the major surface (S₂ₐ) of said integrated circuit chip (BGA, CSP, 2), and that the sum of the heights (h₂₁) of the balls (2-1) projecting from the major surface (S₂ₐ) of said integrated circuit chip (BGA, CSP) and the height (h₂₁) of the electrical connection means (1-1) with its applied solder pattern (1-2) is larger than the height (h₁₃) of the frame solder pattern (1-3) before the soldering process.

9. An electronic circuit module according to claim 5,
***characterized in that***
the bottom surface (S₄ₐ) of said integrated circuit chip (BGA, CSP, 2) projects from the major surface (S₂ₐ) of said integrated circuit chip, and that the sum of the height (h₂₁) of the electrical connection means (2-1) projecting from the integrated circuit chip (2) and the height (h₂₁) of the electrical connection means (1-1) with its applied solder pattern (1-2) is larger than the height (h₁₃) of the frame solder pattern (1-3) and the projection height of the bottom surface (S₄ₐ) of the frame (4-1; 4-2).

10. An electronic circuit module according to claim 9,
***characterized in that***
said frame solder pattern (1-3) is received in a frame recess in said circuit board (1).

11. An electronic circuit module according to claim 5,
***characterized in that***
the bottom surface (S₄ₐ) of the frame (4-1; 4-2) is recessed such that a step is formed between the bottom surface (S₄ₐ) of the frame (4-1; 4-2) and the major surface (S₂ₐ) of the integrated circuit chip (BGA, CSP).

12. A method for mounting an integrated circuit chip (BGA, CSP, 2) to a circuit board (PCB, 1), comprising the following steps:
a) providing (S11) a circuit board (PCB, 1) with an electrical connection means (1-1) ;
b) providing (S12) a solder pattern (1-2) on said electrical connection means (1-1);
c) providing (S13) a frame solder pattern (1-3) on the circuit board (PCB, 1);
d) providing an integrated circuit chip (CSP, BGA, 2) having an continuous frame (4-1; 4-2) formed at least on side surfaces (S_{2b}) thereof, and an electrical connection means (2-1) projecting from a major surface (S₂ₐ) thereof above the circuit board (PCB, 1);
e) lowering (S15) said integrated circuit chip onto the circuit board such that the electrical connection means (2-1) of said integrated circuit chip contacts the solder pattern (1-2) provided on the electrical connection means of the circuit board whilst a distance (d) is kept between the bottom surface (S₄ₐ) of the frame (4-1; 4-2) and the frame solder pattern (1-3);
f) soldering (S16) the electrical connection means (2-1; 1-1) of said integrated circuit chip and said circuit board by heating the solder pattern (1-2) provided on the electrical connection means (1-1) of said circuit board;
g) after completing step f), soldering the frame (4-1; 4-2) to the major surface (S₁ₐ) of the circuit board via said frame solder pattern (1-3).

13. A method according to claim 12,
***characterized in that***
the height (h₂₁) of the electrical connection means (2-1) projecting from the major surface (S₂ₐ) of said integrated circuit chip (BGA, CSP, 2) plus the height (h₂₁) of the solder pattern (1-2) and the electrical connection means (1-1) of said circuit board is, before soldering, larger than the height (h₁₃) of said frame solder pattern (1-3).

14. A method according to claim 13,
***characterized in that***
the bottom surface (S₄ₐ) of said frame (4-1; 4-2) projects from the major surface (S₂ₐ) of said integrated circuit chip (BGA, CSP, 2), and the height (h₂₁) of the projecting electrical connection means (2-1) of said integrated circuit chip (BGA, CSP, 2) plus the height (h₂₁) of the solder pattern (1-2) and the electrical connection means (1-1) of said circuit board (PCB, 1) is larger than the projection height of the bottom surface (S₄ₐ) of said frame (4-1; 4-2) and the height (h₁₃) of the frame solder pattern (1-3).

15. A method according to claim 14,
***characterized in that***
the frame solder pattern (1-3) is provided in a recess of said circuit board (PCB, 1).

16. A method according to claim 15,
***characterized in that***
the solder pattern (1-2) provided on the electrical connection means (1-1) and the frame solder pattern (1-3) provided on a major surface (S₁ₐ) of the circuit board (PCB, 1) are applied via a screen-printing of a solder paste.

17. A communication device including at least one integrated circuit chip in accordance with one or more of claims 1-5.

18. A communication device including at least one electronic circuit module in accordance with one or more of claims 6-11.

19. A communication device in accordance with claim 17 or 18,
***characterized in that***
said communication device is a PDA or a mobile telephone.

20. An electronic circuit module according to claim 6,
***characterized in that***
the frame (4-1, 4-1) and the frame solder pattern (1-3) are misaligned in the lateral direction such that a distance (w) is kept between the inner surface of the frame solder pattern (1-3) and the outward directed surface of the frame (4-1, 4-2).

21. A method according to claim 12,
***characterized in that***
the frame solder pattern (1-3) is provided on the circuit board in such a manner that the frame (4-1) and the frame solder pattern (1-3) are misaligned in the lateral direction such that a distance (w)_is kept between the inner surface of the frame solder pattern (1-3) and the outward directed surface of the frame (4-1, 4-2).
